(19) Europäisches Patentamt
European Patent Office
Office européen des brevets

(11) EP 2 804 041 A1

(12) **EUROPEAN PATENT APPLICATION**

(43) Date of publication:
19.11.2014 Bulletin 2014/47

(51) Int Cl.:
*G02B 26/08* (2006.01)      *G03F 7/20* (2006.01)

(21) Application number: 13167533.2

(22) Date of filing: 13.05.2013

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(71) Applicant: **Nederlandse Organisatie voor Toegepast -Natuurwetenschappelijk Onderzoek TNO 2628 VK Delft (NL)**

(72) Inventors:
• **de Vreugd, Jan**
  **2628 VK  Delft (NL)**
• **Doelman, Nicolaas Jan**
  **2628 VK  Delft (NL)**

(74) Representative: **Jansen, Cornelis Marinus et al V.O.**
**Johan de Wittlaan 7**
**2517 JR Den Haag (NL)**

(54) **Deformable optical system and method for controlling the same as well as a lithographic system comprising the deformable optical system**

(57)    The deformable optical system comprises at least one optical element (10), an actuator facility (20) and a control unit (30). Therein the at least one optical element (10) has a body (12) with a thermal expansion coefficient and the actuator facility (20) serves to exert a force distribution at a main surface (16) of the body (12). The control unit (30) is arranged for controlling the actuator facility (20) in order to control a shape of the body (12). The actuator facility comprises a body layer (22) formed on said main surface (16) of the body (12) and the body layer has a thermal expansion coefficient differing from the thermal expansion coefficient of the body. The actuator facility further comprises a thermal array (24) facing the body layer (22) and distanced from said body layer (22) by a gap (26). The thermal array has a plurality of thermal elements (250, $T_i$, $T_1$,...$T_5$) distributed at a surface of the thermal array facing the body layer that allow for a heat flow between the thermal array and the body layer. The heat flow has an amplitude controlled by the control unit (30) as a function of the position on the thermal array and as a function of time.

FIG. 1

EP 2 804 041 A1

Printed by Jouve, 75001 PARIS (FR)

**Description**

BACKGROUND OF THE INVENTION

Field of the invention

The present invention relates to a deformable optical system.
The present invention further relates to a method for controlling a deformable optical system.
The present invention still further relates to a lithographic system comprising the deformable optical system.

Related Art

The use of mirrors or reflective optics for applications with short wavelength radiation (e.g., <200 nm) is well-known. Reflective optics are required for short wavelength radiation because refractive optics absorb, but do not transmit at these wavelengths. Although reflective optics absorb some shortwave radiation, much of the incident radiation can be reflected with special reflective coatings.

One example of a commercial application for short wavelength radiation compatible mirrors is extreme ultraviolet (EUV) photolithography, which is used in the manufacture of semiconductor devices. The use of short wavelength or EUV radiation (<20 nm) in semiconductor photolithography is being developed to reduce the resolution dimension, which is proportional to wavelength. A smaller resolution dimension allows more devices to be fabricated onto a given area of a wafer.

To accurately project an image onto a wafer through an optical system in photolithography, the image distortion must be very low. For commercial semiconductor production, the image distortion of an optical system should not be greater than 10% of the resolution dimension. Because the resolution dimension of EUV optical systems may be in the 50 to 100 nm range, the distortion must be proportionally small, approximately 5 to 10 nm. If the distortion exceeds 10% of the resolution dimension, excessive lithography errors can occur, resulting in defective integrated circuits.

In order to produce optical systems with less than 10 nm distortion, mirrors and other optical elements used in EUV optical systems must have extremely high dimensional accuracy. Dimensionally correct mirrors have better imaging performance, higher EUV throughput, and longer lifetime between refurbishments. However, such low dimensional tolerances for optical systems make fabrication of acceptable optical elements, such as mirrors, particularly aspheric mirrors, extremely difficult. Dimensional defects in a reflective surface of a mirror can result from inaccurate machining of the optics, and subsequent uneven deposition of reflective coatings, which are used to maximize the reflectivity of EUV optical elements. However, even with dimensionally perfect mirrors, dimensional defects can occur during short wavelength radiation exposure due to thermal loading, reflective coating stress, gravitational loading, and improper maintenance. Out of tolerance mirrors will produce unacceptably high image distortion at the wafer.

Ravensbergen et al. addresses this issue in "Deformable mirrors with thermo-mechanical actuators for extreme ultraviolet lithography: Design, realization and validation". Precision Engineering 37 (2013) 353- 363.
In the mirror design presented therein the mirror is deformed with thermo-mechanical actuators on a back-plate placed perpendicular to the surface of the mirror. The thermo-mechanical actuators are formed as rods having a winding of a Joule heating coil that locally deform the mirror dependent on their temperature depending on their thermal expansion induced by the heat induced by their Joule heating coil. The rods are glued to the mirror.

It is a disadvantage of the known mirror design that creep-effects of the glue may complicate the control of the mirror surface shape. For EUV-applications and the like, wherein the mirror is arranged in an evacuated space use of adhesives has the further disadvantage that deposits may result on the reflective surface of the mirror due to outgassing of the adhesive. In general mounting additional parts on the mirror is undesired. The rods are thermally slow; i.e. a relatively long time is necessary to heat the rods when a positive force (a force directed towards the mirror) has to be exerted at the mirror. A further disadvantage is that the actuation of the mirror has a one-sided nature, where heating the rods is controllable but cooling the rods is non-controllable and depends on the environment conditions of the mirror.

SUMMARY OF THE INVENTION

It is an object of the present invention to provide for an improved deformable optical system that at least mitigates one or more of these disadvantages It is a further object of the present invention to provide for an improved method of controlling a deformable optical system that at least mitigates one or more of these disadvantages.
It is a still further object of the present invention to provide for a lithographic system comprising the deformable optical system wherein one or more of these disadvantages are at least mitigated.

According to a first aspect of the invention an improved deformable optical system is provided, that comprises:

- at least one optical element with a body having a thermal expansion coefficient (which may be temperature dependent)
- an actuator facility for exerting a force distribution at a main surface of the body,
- a control unit for controlling the actuator facility in order to control a shape of the body.

The actuator facility comprises a body layer formed on the main surface of the body. The body layer has a thermal expansion coefficient differing from the thermal expansion coefficient of the body. Preferably the thermal expansion coefficient of the body layer is substantially constant. The actuator facility further comprises a thermal array facing the body layer and distanced from said body layer, so that a gap is present between the thermal array and said body layer. The thermal array has a plurality of thermal elements distributed at a surface of the thermal array facing the body layer. The thermal elements allows for a heat flow between the thermal array and the body layer. The heat flow has an amplitude controlled by the control unit as a function of the position on the thermal array and as a function of time. Accordingly, in the deformable optical system according to the present invention the shape of the body of the optical element is controlled by the spatial temperature distribution of the body layer. A spatial distribution of the temperature of the body layer on its turn is controlled in a contactless way by the temperature distribution of the thermal array. In practice, the body layer can be relatively thin, e.g. in the order of 10 to 100 micron. This enables a fast heating or cooling of the body layer resulting in relatively fast response times. Various coating methods such as vapor deposition or galvanization are suitable for applying the body layer to the body of the optical element, therewith obviating the use of glue. It is a further advantage of the inventive optical system that for different applications the thermal array can be easily replaced, for example by a thermal array having a higher number of thermal elements as the thermal array need not be physically connected to the body of the optical element.

In an embodiment of the inventive optical system the control unit is arranged to control the actuator facility in order to counteract thermo mechanical distortions of the body of the optical element. In many applications optical elements tend to distort due to a thermal load caused by the radiation subject to the optical system. Also other causes may result in distorsions, such as gravitational forces. For example in lithographic applications using EUV radiation, typically, a part of the radiation is absorbed by the optical components, resulting in a heating of these components. It is desired to mitigate distortions of these components, resulting from a heat load or from other causes, as much as possible in order to enable an accurate projection of patterns to be formed in the wafer.

In an embodiment of the deformable optical system according to the present invention the optical element is a mirror having a reflective surface opposite said main surface. The present invention is particularly suitable for control or mitigation of distortions in mirrors. Other examples of optical elements for which the present invention is applicable are lenses, gratings etc.

In an embodiment of the deformable optical system according to the present invention, the body layer has a thermal expansion coefficient higher than the thermal expansion coefficient of the mirror body.

During use, a mirror will be heated at its reflective surface by radiation impingent thereon. Accordingly, the mirror body will have a relatively high temperature as compared to the body layer, which is arranged at a side of the body of the mirror opposite the reflective surface. Due to the relatively high thermal expansion coefficient of the body layer it can be achieved that the body layer at its relatively low temperature expands to substantially the same extent as the body of the mirror at its relatively high temperature. Therewith thermo mechanical distortions can be counteracted with relatively modest differences in the amplitude of the heat flow as a function of the position. The thermal elements may be either heating elements or cooling elements, provided that the average temperature in the body layer is lower than the average temperature in the mirror body, and that the body layer is not cooled too strongly. If the average temperature in the body layer were higher than the average temperature in the body of the mirror, this would have the effect that the reflective surface curves inwards. If the body layer were cooled too strongly, the body layer would shrink instead of expand having the effect that the reflective surface curves outwards.

In an embodiment the body layer has a lower thermal expansion coefficient, and the thermal elements are cooling elements. During operation of the deformable mirror system both the mirror body and the body layer may be cooled below room temperature. Due to the heat induced by radiation impingent on the reflective surface of the mirror body, and as the body layer is arranged closer to the cooling elements, the temperature of the body layer will be further below room temperature than the temperature of the mirror body is. Accordingly it can be achieved that the shrinkage of the mirror body having the relatively high thermal expansion coefficient and experiencing the relatively small temperature drop is comparable to the shrinkage of the body layer having the relatively low thermal expansion coefficient and experiencing the relatively large temperature drop

In another embodiment the body layer has a negative thermal expansion coefficient, and the thermal elements are cooling elements. This embodiment is particularly suitable in cases wherein a strong cooling of the mirror or other optical element is required, but is not possible to cool the mirror body below the normal temperature. If during operation the body layer is cooled to below room temperature it can expand to the same extent as the body of the mirror that is heated to above room temperature by the radiation impingent thereon.

Several options are possible for controlling the amplitude of the heat flow as a function of time and position. As described in more detail in the sequel, the heat flow may for example be controlled by setting a suitable supply power to the thermal elements (heating or cooling elements) by setting a distance between the thermal elements and the body layer or by locally setting a gas pressure in the gap between individual thermal elements and the body layer.

BRIEF DESCRIPTION OF THE DRAWINGS

These and other aspects are described in more detail with reference to the drawing. Therein:

FIG. 1 schematically shows an embodiment of a deformable optical system according to the first aspect of the invention,
FIG. 1A schematically shows a top view of a thermal array forming part of the optical system,
FIG. 2 shows a sensor arrangement for use in an embodiment of a deformable optical system according to the first aspect of the invention,
FIG. 3A schematically shows an embodiment of a thermal array, with a first example of a thermal element
FIG. 3B illustrates an exemplary temperature distribution in the array,
FIG. 4 shows a second example of a thermal element,
FIG. 5 shows a third example of a thermal element,
FIG. 6 shows a fourth example of a thermal element,
FIG 7A and 7B show a thermal array comprising a plurality of thermal elements according to said fourth example, Therein 7A is a cross-section according to VIIA-VIIA in FIG. 7B and 7B is a top-view according to VIIB in FIG. 7A,
FIG. 8 illustrates an example of a lithographic system wherein the present invention is applicable.
FIG. 9 shows a conventional mirror.

DETAILED DESCRIPTION OF EMBODIMENTS

Like reference symbols in the various drawings indicate like elements unless otherwise indicated.
In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.
The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity.
Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.
Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein. All publications, patent applications, patents, and other references mentioned herein are incorporated by reference in their entirety. In case of conflict, the present specification, including definitions, will control. In addition, the materials, methods, and examples are illustrative only and not intended to be limiting.
In the sequel it is presumed that the optical element concerned is a mirror. Nevertheless, the present invention is also applicable to other types of optical elements, such as lenses and gratings.

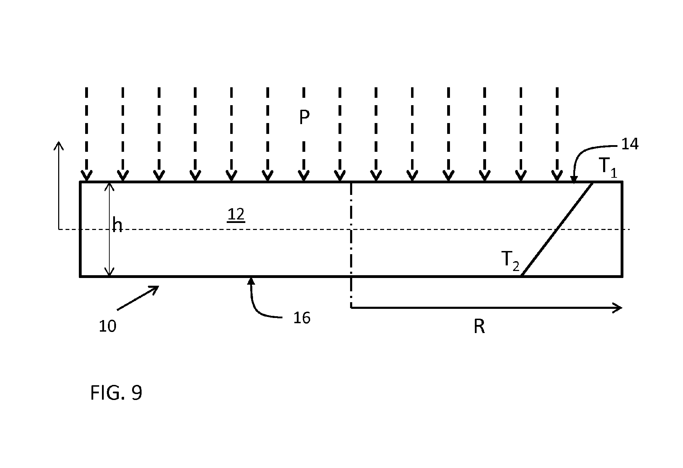

FIG. 9 schematically shows a conventional mirror 10, having a mirror body with a radius R (e.g. 250 mm) and a height h (e.g. 200 mm).
As a result of a power P of radiation absorbed by the mirror the mirror assumes a relatively high temperature $T1$ at its irradiated surface, i.e. the reflective surface 14 and a relatively low temperature $T2$ at the main surface 16 opposite the reflective surface. The temperature decreases approximately linearly in a direction from the irradiated, reflective surface 14 of the mirror body 12 to the main surface 16, from the value $T1$ to the value $T2$.
If it is presumed that the temperature $T2$ is kept at a fixed value, then the value of the temperature $T1$ amounts to

$$T_1 = \frac{P}{k} + T_2,$$

Wherein

$$k = \lambda \frac{A}{h},$$

Therein $\lambda$ is the heat-conduction coefficient, e.g. 1.46 W/mK for Zerodur A is the surface of the mirror receiving the radiation, i.e. $A = \pi R2$.

This results in a mirror deformation of

$$\frac{1}{\rho} = \frac{12\alpha}{h^3} \int_{-h/2}^{h/2} T(z)dz$$

Therein $\alpha$ is the thermal expansion coefficient, e.g. 0.05E-6 K$^{-1}$ for Zerodur

In lithographic applications, a maximum is set to the out of plane deformation (sag $\delta$) of the mirror in order to guarantee a sufficiently accurate mapping of the mask onto the wafer. A typical value for $\delta$ in EUV applications is 1 nm. From this value a minimum value for the radius of curvature $\rho$ can be calculated with the relation:

$$\rho = \frac{R^2 + \delta^2}{2\delta} \approx \frac{R^2}{2\delta}$$

Under practical circumstances, e.g. a heat load of 20 W the sag $\delta$ would be substantially higher than allowed, e.g. in the order of 100 nm.

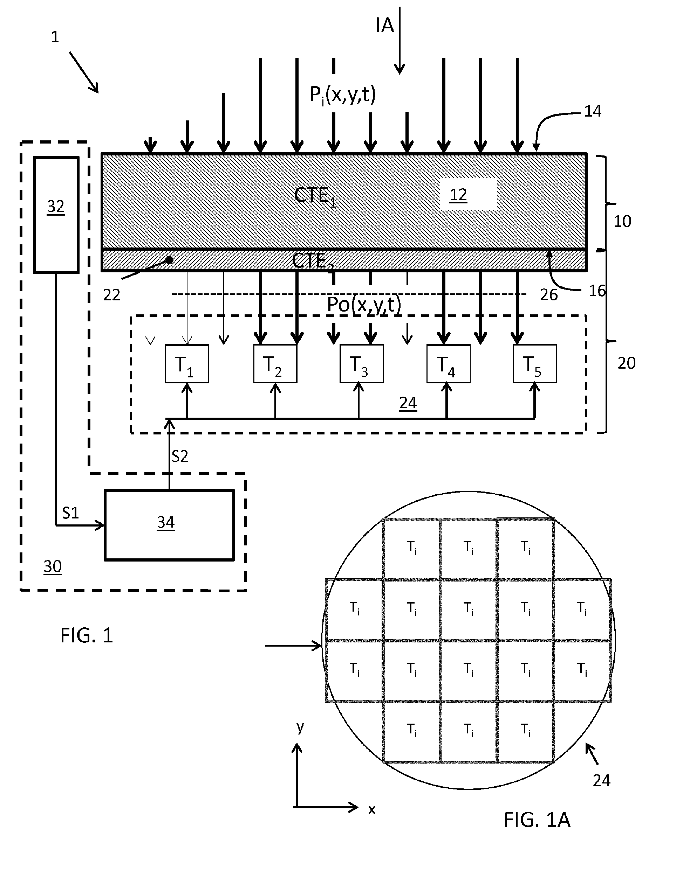

FIG. 1 schematically shows an embodiment of an improved deformable optical system 1. The deformable optical system comprises a mirror 10 with a body 12 (mirror body) and a reflective surface 14, an actuator facility 20 for exerting a force distribution at a main surface 16 of the mirror body opposite the reflective surface 14, and a control unit 30 for controlling the actuator facility 20.

The reflective surface 14 is the optically functional surface of the mirror 10, serving to reflect a beam of radiation. Typically the beam has a power density that is a function of the position x,y on the mirror and the time t. In lithographic applications a particular power distribution over the reflective surface may result from a mask present in the optical path, used as the template for a pattern to be formed in a wafer. Different masks may be used in time and also the power of the radiation source for generating the beam may fluctuate in time. Dependent on the application the material of the mirror body 12 itself may form a reflective surface, or a reflective surface may be formed by a reflective layer or stack of layers, e.g. in the form of a Bragg reflector. The mirror body 12 has a thermal expansion coefficient. A suitable value for the thermal expansion coefficient of the mirror body 12 depends on the application wherein the mirror system is used. In applications wherein the reflective surface 14 should have a substantially constant profile, e.g. in lithographic applications, the ratio R of the thermal expansion coefficient divided by the thermal conductivity preferably is as low as possible. A suitable material for the mirror body 12 in these applications is for example Zerodur. This material has a thermal expansion coefficient of $\alpha$ = 0.05E$^{-6}$ K$^{-1}$ and a thermal conductivity of 1.46 W.m$^{-1}$.K$^{-1}$. The ratio R therewith amounts to 0.034 m.W$^{-1}$. An even better material for this purpose is SiC, which has a thermal expansion coefficient of $\alpha$ = 2.5E$^{-6}$ K$^{-1}$ and a thermal conductivity of 180 W.m$^{-1}$.K$^{-1}$. The ratio R for this material therewith amounts to 0.014 m.W$^{-1}$. In applications wherein a controllable profile of the reflective surface 14 is required, e.g. in applications wherein the profile of the reflective surface 14 should compensate for wavefront abberations in a beam to be reflected, the ratio R may have a higher value.

The actuator facility 20 comprises a body layer 22 formed on said main surface 16 of the mirror body 12. The body layer 22 has a thermal expansion coefficient differing from the thermal expansion coefficient of the mirror body 12.

In the deformable optical system according to the present invention wherein the optical element 10 has a body 12 and a body layer 22, with mutually different thermal expansion coefficients, thermo mechanical deformations can be at least substantially mitigated, i.e. a substantial lower value for the sag $\delta$ can be achieved as can be seen by the calculation. Therein it is presumed that the (mirror) body 12 has a Youngs modulus E1, a thermal expansion coefficient $\alpha_1$, a thickness $h_1$, and a Poisson ratio $v_1$, and further a body layer 22 having a Youngs modulus E2, a thermal expansion coefficient $\alpha_2$, a thickness $h_2$, and a Poisson ratio $v_2$.

The radius of curvature $\rho$ of the optical element can then be calculated as follows:

$$\frac{1}{\rho} = \frac{1}{D}\left(\left[(1-v_2)E_1h_1 + (1-v_1)E_2h_2\right]\right) \times \left[(1-v_2)\alpha_1 E_1 \int_{-h1}^{0} \tau.z.dz + (1-v_1)\alpha_2 E_2 \int_{0}^{h2} \tau.zdz\right]$$
$$-\frac{1}{2}\left[-(1-v_2)E_1h_1^2 + (1-v_1)E_2h_2^2\right] \times \left[(1-v_2)\alpha_1 E_1 \int_{-h1}^{0} \tau.dz + \left((1-v_1)\alpha_2 E_2 \int_{0}^{h2} \tau dz\right)\right]$$

Therein:

$$D = \frac{1}{12}\left(\left[(1-v_2)E_1h_1^2 + (1-v_1)E_2h_2^2\right] + 4(1-v_1)(1-v_2)E_1 E_2 h_1 h_2\left(h_1^2 + h_1 h_2 + h_2^2\right)\right)$$

From this computation it can be seen that the presence of the body layer 22 on the mirror body 12 renders it possible to mitigate thermo-mechanical effects presuming a homogeneous distribution of the heat flow over the reflective surface of the mirror.

For example, it is presumed that a mirror body 12 of Zerodur is used having a mirror radius of 250 mm, a thickness h of 200 mm, and a body layer 22 of 10 $\mu$m.. Suitable materials for the body layer are for example Nickel and Aluminium as further detailed below.

Example 1: Nickel

This material has the following properties:

E = 200 GPa, v = 0.31, CTE = 13.4·10-6 $K^{-1}$,

Presuming a thermal load of the reflective surface 14 of the mirror of 20 W for example, the required heat transfer gas constant is 2.14 $W.m^{-2}.K^{-1}$.

For nickel, which has a heat transfer coefficient of 2 $W.m^{-2}.K^{-1}$, this can be realized with a gap 26 of 100 $\mu$m, filled with nitrogen gas at a pressure of 0.015 mbar.

Example 2: Aluminum

This material has the following properties:

E = 70 GPa, v = 0.31, CTE = 24·$10^{-6}$ $K^{-1}$. The heat transfer coefficient for aluminium is 1.14 $W.m^{-2}.K^{-1}$. Presuming again a thermal load of 20 W, a proper cooling can be achieved with a gap 26 of 100 $\mu$m, filled with nitrogen gas at a pressure of 0.010 mbar.

The actuator facility 20 further comprises a thermal array 24 facing the body layer 22 and distanced therefrom, so that a gap 26 is present between the thermal array 24 and the body layer 22. The thermal array 24 has a plurality of thermal elements $T_i$ distributed at a surface of the thermal array 24 facing the body layer 22. The thermal elements $T_i$ allows for a heat flow $P_0(x,y,t)$ between the thermal array 24 and the mirror body 12. The heat flow has an amplitude as a function of the position x,y and time t on the thermal array that is controlled by the control unit 30.

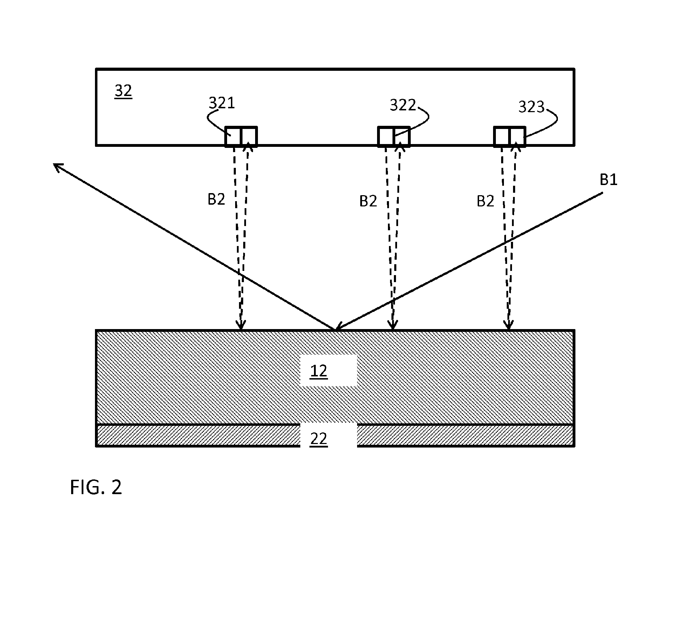

In the embodiment shown, the control unit 30 has a sensor arrangement 32 for sensing an actual profile of the reflective surface 14 and providing an output signal S1 indicative for the sensed profile. The control unit 30 further has a steering arrangement 34 for steering the thermal elements $T_i$ with steering signals S2 according to a feedback mechanism reacting on the sensor signal S1. As shown in FIG. 2, the sensor arrangement 32 comprises for example interferometer elements 321, 322, 322 that measure a height profile of the reflective surface, using radiation beams B2 with an alignment differing from the alignment of the beam B1. Alternatively, a sensor arrangement 32 may be absent, and the steering arrangement 34 may control the actuator facility according to a feedforward control mechanism that calculates the steering signals S2 on the basis of expected compensation requirements. The expectation may be based on an estimation of the thermal load $P_i(x,y,t)$ e.g. calculated from the input power and a particular mask used. In again another application, the steering arrangement 34 may combine feedforward control and feedback control.

In an embodiment of the deformable mirror system shown in FIG. 1, the body layer 22 has a thermal expansion coefficient higher than the thermal expansion coefficient of the body 12. In this embodiment, the body layer 22 is for example formed of a metal coating on the mirror body 12, e.g. from a metal as aluminum, nickel or titanium having a linear temperature expansion coefficient of $22*10^{-6}$ K$^{-1}$, $13.4*10^{-6}$ K$^{-1}$ and $8.6*10^{-6}$ K$^{-1}$ respectively The metal layer may be applied by a vapor deposition method e.g. by a CVD or a PVD method or by a galvanization process for example.

During use, the mirror 10 will be heated at its reflective surface 14 by radiation impingent thereon. Accordingly, the mirror body 12 will have a relatively high temperature as compared to the body layer 22, which is arranged at a side of the mirror body opposite the reflective surface. Due to the relatively high thermal expansion coefficient of the body layer 22 it can be achieved that the body layer 22 at its relatively low temperature tends to expand to substantially the same extent as the mirror body at its relatively high temperature, so that a profile of the reflective surface remains substantially constant.

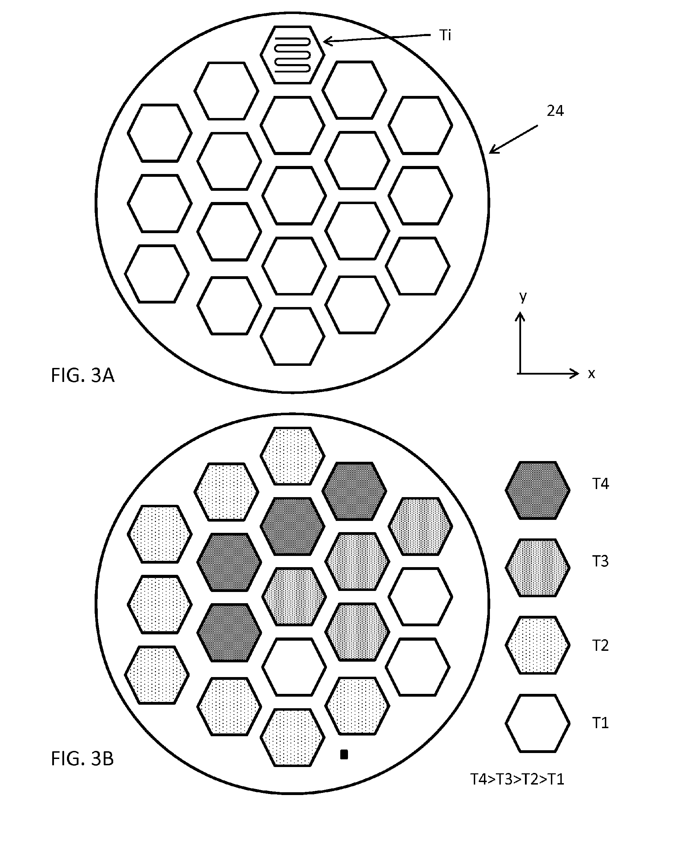

Accordingly, a suitable choice of the materials used for the mirror body 12 and the body layer 22 as well as a dimensioning of their thicknesses, already provides for a substantial passive compensation for thermal expansion in the mirror body 12. In that case the contribution of active compensation controlled by the control unit can be relatively modest, therewith reducing the requirements of the thermal elements Ti. The body layer 22 may be selected to slightly undercompensate thermally induced deformations of the mirror and the elements can be used as the thermal elements to locally cause an additional expansion in the body layer 22 that provides for a full compensation. Alternatively the body layer 22 may be selected to slightly overcompensate thermally induced deformations of the mirror and cooling elements can be used to locally cause a reduced expansion of the body layer 22 to correct for this overcompensation. Embodiments of a thermal array are described in more detail below with reference to FIG. 3A, 3B, 4,5,6, 7A and 7B.

In another embodiment the body layer 22 has a negative thermal expansion coefficient, and the thermal elements are cooling elements. Typical materials having a negative thermal expansion coefficient are the $AM_2O_8$ family of materials (where A = Zr or Hf, M = Mo or W) such as $Zr(WO_4)_2$ and the $A_2(MO_4)_3$. But also other examples are known, such as $ZrV_2O_7$ and $ScF_3$. By way of example, the material zirconium tungstate $Zr(WO_4)_2$ has a thermal expansion coefficient of $-7.2 \cdot 10^{-6}$ K$^{-1}$.

If during operation the body layer 22 is cooled to below room temperature it can expand to the same extent as the mirror body 12 that is heated to above room temperature by the radiation impingent thereon. Accordingly, this embodiment allows a strong cooling of the optical element, i.e. the mirror 10 in this case, while compensating for thermally induced deformation of the mirror.

FIG. 3A illustrates an embodiment of a thermal array 24, having hexagonally shaped heating elements as the thermal elements. In this case, the heating elements comprise a Joule heating element as is schematically illustrated for one of the thermal elements indicated with Ti. In this way an arbitrary desired temperature distribution as a function of the coordinates x,y over the surface of the thermal array 24 facing the body layer 22 can be achieved as illustrated by way of example in FIG 3B by suitably controlling the power supplied by the steering arrangement to each heating element. The temperature is indicated by the hatched fields T1, T2, T3, T4.

In another embodiment the thermal array comprises cooling elements (e.g. Peltier elements) as the thermal elements. As for heating elements the temperature of individual cooling elements may be controlled by regulating a supplied voltage. Alternatively or in addition, an emissivity of the thermal array may be locally controlled, for example by using electrochromatic elements 240 in front of the thermal array 24, of which one specimen 240 is illustrated in 241. In the example shown, the electrochromatic element 240 subsequently comprises in a top-down direction, a radiation transmissive window 241, a surface active redox polymer 242, a slitted gold/Mylar working electrode 243, a porous electrode separator 244, a counter electrode polymer 245, a gold/Mylar counter electrode 246, arranged on a substrate 247, e.g. from an organic material, such as PEN or PET.

In again another embodiment the thermal array may comprise a combination of cooling and heating elements. Likewise in such a thermal array the emissivity may be locally controlled, e.g. by electrochromatic elements.

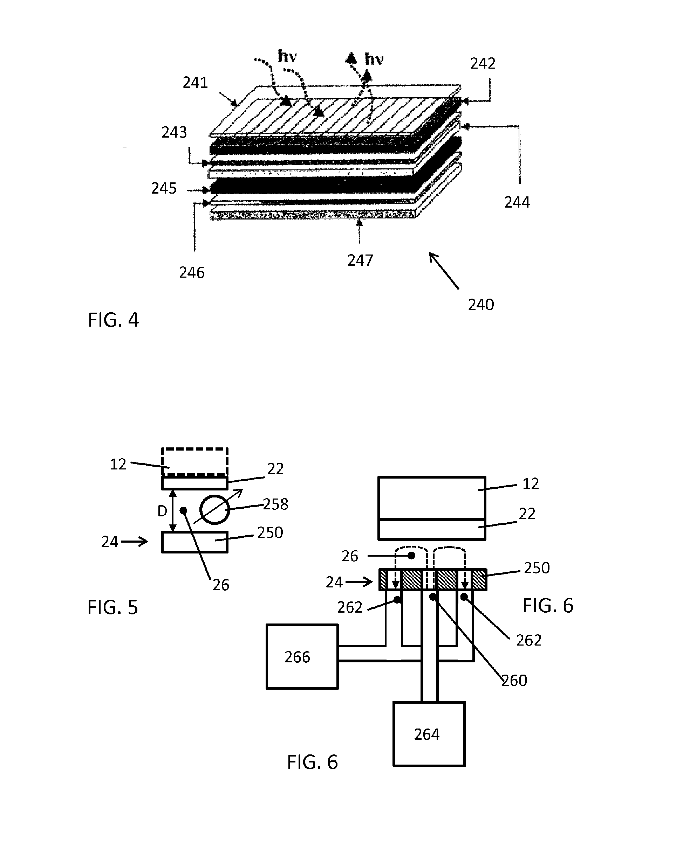

Also other options are possible for controlling the amplitude of the heat flow as a function of the position. In an embodiment illustrated in FIG. 5, (the steering arrangement 34 of) the control unit 30 is arranged to steer an actuator 258 that controls a distance D between the cooling elements 250 and the body layer 22.

In another embodiment, shown in FIG. 6, the control unit 30 controls a pressure of a gas present in the gap 26 between the thermal array 24 and the body layer 22. Spatial differences in gas pressure may be provided by providing the thermal array with spatially distributed gas flow openings and providing a respective gas flow through each gas flow opening. In the embodiment shown the thermal element 250 has a central gas inflow opening 260 and peripheral gas outflow openings 262.

The gas inflow opening 260 is coupled to a gas supply facility 264 to provide gas with a pressure or flow controlled by the control unit 30. The gas outflow openings 262 are coupled to a gas exhaust facility 266 to exhaust the gas in a way controlled by the control unit 30. The control unit 30 regulates the gas supply facility 264 and/or the gas exhaust facility 266 in order to achieve a desired temperature distribution over the body layer 22. Alternatively or in addition a temperature of the gas may be controlled in accordance with a spatial distribution.

A suitable tuning of the exhaust facility 266 to the gas supply facility 264 may already provide for an adequate decoupling of the thermal elements in an arrangement using spatial differences in gas pressure.

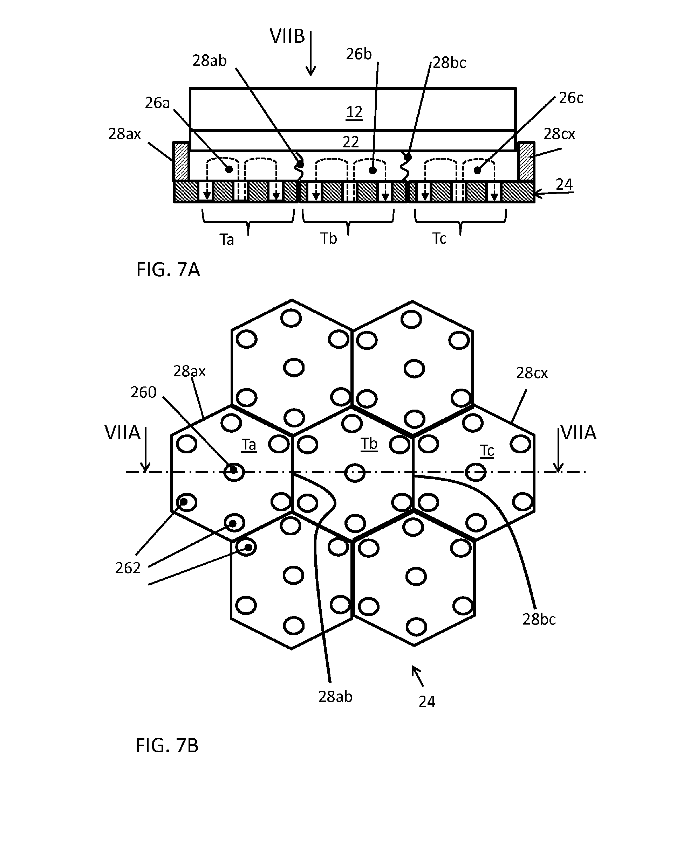

FIG. 7A, schematically shows a cross-section through a deformable optical system comprising a mirror body 12 with a body layer 22, and a thermal array 24 of which thermal elements Ta, Tb, Tc are shown. FIG. 7B shows a top-view of the thermal array 24 according to VIIB in FIG. 7A. For clarity the mirror and the body layer are not shown in FIG 7B. FIG. 7B shows the line VIIA-VIIA according to which the cross-section of FIG. 7A is taken.

In the embodiment illustrated in FIG. 7A, 7B a flexible sealing, e.g. of a rubber is present between each thermal element Ta, Tb, Tc etc and a respective portion of a surface of the body layer 22 so that different compartments 26a, 26b, 26c are formed that each can have a respective gas pressure. This is illustrated in FIG. 7A, 7B. The flexible sealing comprises flexible sealing wall portions between each pair of thermal elements, e.g. a wall portion 28ab between thermal elements Ta, Tb, and a wall portion 28bc between thermal elements Tb, Tc. Additionally wall portions are present between the outer thermal elements and the environment, e.g. see wall portion 28ax between thermal element Ta and the environment, and a wall portion 28cx between thermal element Tc and the environment. In an embodiment only a flexible sealing is present to atmospherically separate the gap 26 from the environment. This is also applicable in other embodiments wherein it is desired that the optical path extends in a substantially evacuated atmosphere, and that a certain gas pressure is maintained in the gap 26. A very suitable gas for supporting heat transfer is hydrogen. This gas however easily diffuses through materials which is a disadvantage in optical systems that require that the optical path is arranged in an evacuated space. Another suitable gas, not having this disadvantage is nitrogen.

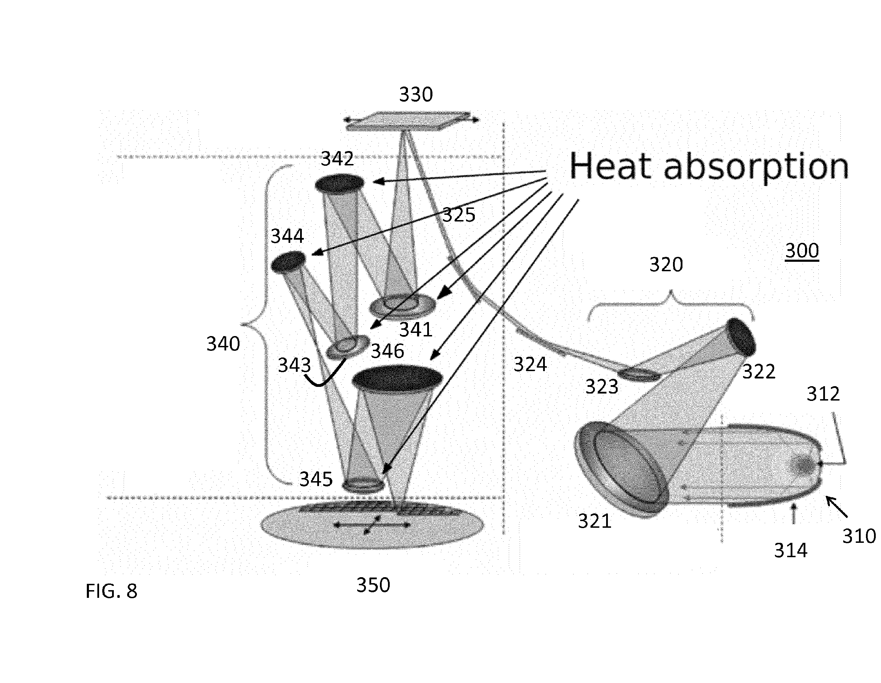

The present invention is particularly suitable for application in a lithographic arrangement, as it allows control of the profile of the optical components to a high accuracy while it allows an efficient cooling of the optical components, which are typically exposed to a large heat load. FIG. 8 illustrates an example of such an arrangement 300.

The lithographic arrangement 300 shown in FIG. 8 comprises a EUV-radiation source 310 including a facility for a EUV generating plasma 312 and a EUV source collector 314. The EUV beam generated with the EUV-radiation source 310 is guided by illuminator optics 320, comprising mirrors 321, 322, 323, 324, 325 to a reflective mask 330. The image reflected by the reflective mask 330 is mapped by projection optics 340 to a wafer 350. In the embodiment shown the projection optics 340 includes a set of 6 mirrors 341, 342, 343, 344, 345, 346. Each of the optical elements described with reference to FIG. 8 is subject to a large heat load, and as a result may have tendency to deform during use. Nevertheless a mitigation thermo mechanical deformation is in particular important for the optical components forming part of the projection optics 340, i.e. the mirrors 341-346 as these components have to accurately map an image of the mask 330 on the wafer 350. Accordingly, preferably at least one of these mirrors is formed as a deformable mirror system according to the present invention.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

**Claims**

1. A deformable optical system comprising

   - at least one optical element (10) having a body (12) with a thermal expansion coefficient,
   - an actuator facility (20) for exerting a force distribution at a main surface (16) of the body (12),
   - a control unit (30) for controlling the actuator facility (20) in order to control a shape of the body (12),

   **characterized in that** the actuator facility comprises a body layer (22) formed on said main surface (16) of the body (12), the body layer having a thermal expansion coefficient differing from the thermal expansion coefficient of the body, the actuator facility further comprising a thermal array (24) facing the body layer (22) and distanced from said body layer (22), a gap (26) being present between the thermal array (24) and said body layer (22), the thermal array having a plurality of thermal elements (250, $T_i, T_1, ... T_5$) distributed at a surface of the thermal array facing the body layer, the thermal elements allowing for a heat flow between the thermal array and the body layer, the heat flow having an amplitude controlled by the control unit (30) as a function of the position on the thermal array and as a function of time.

**2.** A deformable optical system according to claim 1, wherein the control unit (30) is arranged to control the actuator facility (20) in order to counteract distorsions of the body (12).

**3.** A deformable optical system according to claim 1 or 2, wherein said optical element (10) is a mirror having a reflective surface (14) opposite said main surface (16).

**4.** A deformable mirror system according to claim 1, wherein the body layer (22) has a thermal expansion coefficient higher than the thermal expansion coefficient of the body (12).

**5.** A deformable mirror system according to claim 1, wherein the body layer (22) has a thermal expansion coefficient lower than the thermal expansion coefficient of the body (12), and wherein the thermal elements (250, $T_i, T_1, ... T_5$) are cooling elements.

**6.** A deformable mirror system according to claim 5, wherein the body layer (22) has a negative thermal expansion coefficient, and wherein the thermal elements (250, $T_i, T_1, ... T_5$) are cooling elements.

**7.** A deformable mirror system according to claim 1, wherein the control unit (30) controls a temperature of the thermal elements (250, $T_i, T_1, ... T_5$).

**8.** A deformable mirror system according to claim 1, wherein the control unit (30) controls the emissivity of the thermal elements (250, $T_i, T_1, ... T_5$).

**9.** A mirror system according to claim 1, wherein the control unit (30) controls a distance (D) between the cooling elements (250) and the body layer (22).

**10.** A mirror system according to claim 1, wherein the control unit (30) controls a pressure of a gas present in the gap (26) between the thermal array (24) and said body layer (22).

**11.** A lithographic arrangement (300) comprising a mirror system according to one of the previous claims.

**12.** Method of controlling a deformable optical system comprising

- providing at least one optical element (10) with a body (12) having a thermal expansion coefficient,
- providing an actuator facility (20) for exerting a force distribution at a main surface (16) of the body (12),
- controlling the actuator facility (20) in order to control a shape of the body,

**characterized in that** providing the actuator facility (20) comprises providing a body layer (22) formed on said main surface (16) of the body (12), the body layer (22) having a thermal expansion coefficient differing from the thermal expansion coefficient of the body (12), said providing the actuator facility further comprising providing a thermal array (24) facing the body layer (22) and distanced from said body layer (22), a gap (26) being present between the thermal array and said body layer (22), the thermal array (24) having a plurality of thermal elements (250, $T_i, T_1, ... T_5$) distributed at a surface of the thermal array facing the body layer, the thermal elements allowing for a heat flow between the thermal array and the body layer, wherein said controlling comprises controlling an amplitude of the heat flow as a function of the position on the thermal array and as a function of time..

1

IA

$P_i(x,y,t)$

14

CTE₁                    12

10

CTE₂

22                                    26        16

$Po(x,y,t)$

| $T_1$ | $T_2$ | $T_3$ | $T_4$ | $T_5$ |

24

20

32

S2

S1

34

30

**FIG. 1**

$T_i$  $T_i$  $T_i$

$T_i$  $T_i$  $T_i$  $T_i$  $T_i$

$T_i$  $T_i$  $T_i$  $T_i$  $T_i$

$T_i$  $T_i$  $T_i$

y

x

24

**FIG. 1A**

FIG. 2

FIG. 3A

FIG. 3B

T4>T3>T2>T1

FIG. 4

FIG. 5

FIG. 6

VIIB

28ab

26b

28bc

26a

12

26c

28ax

22

28cx

24

Ta          Tb          Tc

FIG. 7A

28ax

260

28cx

VIIA

Ta          Tb          Tc

VIIA

262

28bc

262

28ab

24

FIG. 7B

FIG. 8

FIG. 9

**EP 2 804 041 A1**

Europäisches Patentamt
European Patent Office
Office européen des brevets

**EUROPEAN SEARCH REPORT**

Application Number

EP 13 16 7533

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2005 300709 A (NAT INST OF ADV IND & TECHNOL; SHINKA SYSTEM SOGO KENKYUSHO K) 27 October 2005 (2005-10-27) * paragraph [0016] - paragraph [0017]; figure 1 * | 1-12 | INV. G02B26/08 G03F7/20 |
| X | FR 2 946 761 A1 (EUROP DE SYSTEMES OPTIQUES SOC [FR]) 17 December 2010 (2010-12-17) * page 5, line 12 - page 9, line 3; figures 1-5 * | 1-12 | |
| A | JP 2011 129576 A (NIPPON KOGAKU KK) 30 June 2011 (2011-06-30) * paragraph [0064]; example 3 * | 5,6 | |
| A | JP 2005 140999 A (NIPPON KOGAKU KK) 2 June 2005 (2005-06-02) * paragraph [0035] - paragraph [0036]; figure 3 * | 5,6 | |
| A,D | S.K. RAVENSBERGEN ET AL: "Deformable mirrors with thermo-mechanical actuators for extreme ultraviolet lithography: Design, realization and validation", PRECISION ENGINEERING, vol. 37, no. 2, 23 October 2012 (2012-10-23), pages 353-363, XP055068609, ISSN: 0141-6359, DOI: 10.1016/j.precisioneng.2012.10.004 * abstract * | 1,12 | TECHNICAL FIELDS SEARCHED (IPC) G02B G03F |

The present search report has been drawn up for all claims

| Place of search | Date of completion of the search | Examiner |
|---|---|---|
| The Hague | 28 June 2013 | Lehtiniemi, Henry |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

17

**ANNEX TO THE EUROPEAN SEARCH REPORT
ON EUROPEAN PATENT APPLICATION NO.**

EP 13 16 7533

This annex lists the patent family members relating to the patent documents cited in the above-mentioned European search report.
The members are as contained in the European Patent Office EDP file on
The European Patent Office is in no way liable for these particulars which are merely given for the purpose of information.

28-06-2013

| Patent document cited in search report | | Publication date | Patent family member(s) | | Publication date |
|---|---|---|---|---|---|
| JP 2005300709 | A | 27-10-2005 | JP | 4340728 B2 | 07-10-2009 |
| | | | JP | 2005300709 A | 27-10-2005 |
| FR 2946761 | A1 | 17-12-2010 | EP | 2443505 A1 | 25-04-2012 |
| | | | FR | 2946761 A1 | 17-12-2010 |
| | | | WO | 2010146256 A1 | 23-12-2010 |
| JP 2011129576 | A | 30-06-2011 | NONE | | |
| JP 2005140999 | A | 02-06-2005 | NONE | | |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **RAVENSBERGEN et al.** Deformable mirrors with thermo-mechanical actuators for extreme ultraviolet lithography: Design, realization and validation. *Precision Engineering,* 2013, vol. 37, 353-363